# EUROPÄISCHE PATENTSCHRIFT

(11) **EP 1 390 980 B1**
(45) Veröffentlichungstag und Bekanntmachung des Hinweises auf die Patenterteilung: **13.10.2004**
(21) Anmeldenummer: 02742988.5
(22) Anmeldetag: 10.05.2002
(51) Int. Cl.: H01L 27/02, H01L 29/735, H01L 29/732

(54) **HALBLEITERSTRUKTUR MIT ESD-SCHUTZEINRICHTUNG**
SEMICONDUCTOR STRUCTURE COMPRISING AN ELECTROSTATIC DISCHARGE (ESD) PROTECTION DEVICE
STRUCTURE A SEMICONDUCTEURS COMPORTANT UN DISPOSITIF DE PROTECTION CONTRE LES DECHARGES ELECTROSTATIQUES

(30) Priorität: 31.05.2001 DE 10126628
(43) Veröffentlichungstag der Anmeldung: 25.02.2004
(73) Patentinhaber: Infineon Technologies AG, 81669 München (DE)
(72) Erfinder: DIEFENBECK, Klaus, 81247 Muenchen (DE); GNANNT, Klaus, 86391 Stadtbergen (DE); HUBER, Jakob, 83104 Beyharting (DE); KRUMBEIN, Ulrich, 83026 Rosenheim (DE)
(74) Vertreter: Zimmermann, Tankred Klaus
(86) Internationale Anmeldenummer: PCT/EP2002/005172
(87) Internationale Veröffentlichungsnummer: WO 2002/097886

(56) Entgegenhaltungen:
- DE-A- 4 200 884
- PATENT ABSTRACTS OF JAPAN vol. 1997, no. 10, 31. Oktober 1997 (1997-10-31) -& JP 09 148338 A (SONY CORP), 6. Juni 1997 (1997-06-06)
- PATENT ABSTRACTS OF JAPAN vol. 1998, no. 11, 30. September 1998 (1998-09-30) -& JP 10 172981 A (SONY CORP), 26. Juni 1998 (1998-06-26)
- PATENT ABSTRACTS OF JAPAN vol. 2000, no. 05, 14. September 2000 (2000-09-14) -& JP 2000 058870 A (NIPPON INTER ELECTRONICS CORP), 25. Februar 2000 (2000-02-25)

## Beschreibung

Die vorliegende Erfindung bezieht sich auf eine Halbleiterstruktur mit einer ESD-Schutzeinrichtung und insbesondere auf eine Bipolartransistorstruktur mit einer ESD-festen Basis-Kollektor-Diode (ESD = Electro Static Discharge = elektrostatische Entladung).

Bei den elektronischen Bauelementen, wie sie heutzutage mit immer kleiner werdenden Geometrien bei gleichzeitiger Zunahme der Integrationsdichte gefertigt und verwendet werden, besteht aufgrund der ansteigenden Empfindlichkeit eine Gefahr der Beschädigung oder Zerstörung derselben im Falle von elektrostatischen Entladungen. Die Bauelemente sind daher gegen solche elektrostatische Entladungen zu schützen, was zum einen durch eine entsprechende Handhabung derselben in Schutzzonen erreicht werden kann, jedoch nur das Eintreten der elektrostatischen Entladung verhindert, ohne dass die Bauelemente selbst irgendwelche Schutzmaßnahmen aufweisen würden.

Beispielhaft seien hier Hochfrequenztransistoren betrachtet, die aufgrund ihrer kleinen Kapazitäten besonders durch eine elektrostatische Entladung (ESD) gefährdet sind. Das Problem bei solchen Hochfrequenztransistoren besteht darin, dass die Forderung nach guten Hochfrequenzeigenschaften und Robustheit gegen eine ESD-Überlastung sich weitgehend widersprechen.

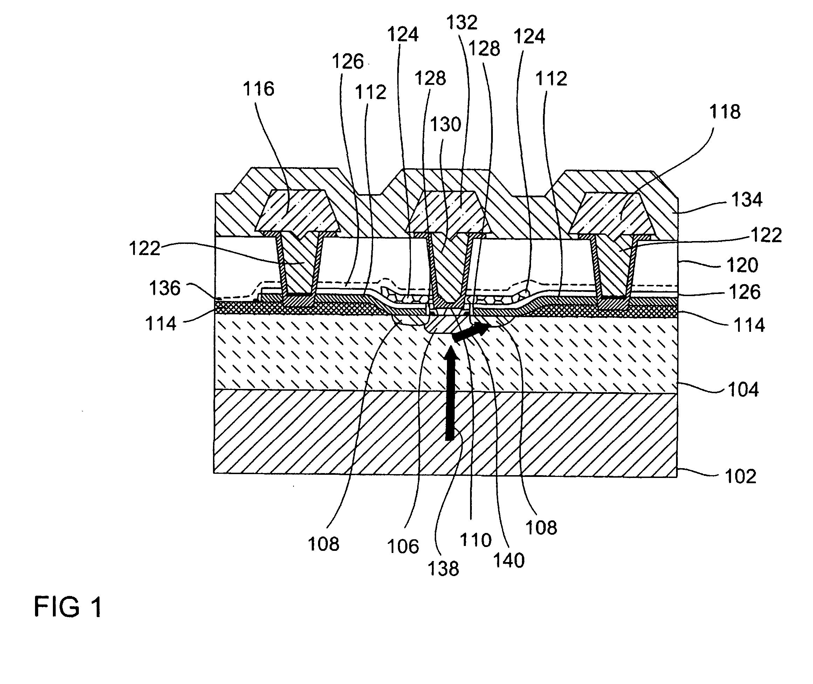

Anhand der Fig. 1 wird nachfolgend ein im Stand der Technik bekannter Hochfrequenztransistor näher erläutert, sowie die im Falle einer ESD-Überlastung auftretenden Probleme.

Üblicherweise besteht ein Hochfrequenztransistor aus einer parallelen Anordnung von mehreren Emitter- und Basisfingern, wobei bereits ein Emitterfinger und zumindest ein Basisfinger einen voll funktionsfähigen Transistor bilden. In Fig. 1 ist ein Transistor mit einem Emitterfinger und zwei Basisfingern gezeigt. Aufgrund der gegebenen Symmetrie und aus Gründen der Übersichtlichkeit ist es ausreichend nur eine Grundzelle des Transistors zu betrachten.

Die Halbleiterstruktur umfasst ein hochdotiertes Substrat 102 aus einem n-Material. Auf dem Substrat ist eine niedrig dotierte Epitaxieschicht 104 aufgewachsen. Das Substrat 102 bildet einen sogenannten "Subkollektor", der von der Rückseite her nach außen elektrisch kontaktiert wird, und die Epitaxieschicht 104, die ebenfalls aus einem n-Material besteht, bildet den aktiven Kollektor.

In Fig. 1 ist ein Transistor gezeigt, bei dem der Kollektor durch das Substrat nach hinten herausgeführt ist. Der äußere Kollektoranschluss (hier nicht gezeigt) wird über die Rückseite des Halbleiter-Transistorchips über metallische Schichten herangeführt. Eine solche Konstruktion ist bei diskreten Hochfrequenz-Transistoren sehr verbreitet, während bei integrierten Transistoren der Kollektoranschluss nach oben herausgeführt werden muss. Dazu nutzt man ein Substrat der entgegensetzten Dotierungsart, und bringt eine hochdotierte Schicht, einen sogenannten "buried layer", von der gleichen Dotierungsart wie der aktive Kollektor ein. Dieser "buried layer" wird über eine sogenannte "Sinkerdiffusion" von oben her angeschlossen. Der "buried layer" aus der IC-Technologie hat die gleiche Funktion wie das Substrat. Die nachfolgenden Ausführungen gelten analog auch für einen IC-Transistor.

In der Epitaxieschicht 104 ist ein Basisbereich 106 aus einem p-Material gebildet. Dem Basisbereich 106 ist ein Basisanschluss 108 zugeordnet. Der Basisanschluss 108 ist beidseitig des Basisbereichs 106 in der Schicht 104 gebildet. In dem Basisbereich 106 ist ferner ein Emitterbereich 110 angeordnet, der aus einem n-Material hergestellt ist. Der Emitterbereich 110 ist derart in dem Basisbereich 106 gebildet, dass dieser vollständig in demselben gebildet ist, also von dem Basisanschluss 108 beabstandet ist. Durch den Emitterbereich 110, den Basisbereich 106 und den Kollektor 104 ist ein npn-Transistor gebildet.

Die Halbleiterstruktur 100 umfasst ferner Basisanschlussleitungen 112. Die Basisanschlussleitungen 112 sind durch eine isolierende Schicht 114, die auf der Epitaxieschicht 104 aufgebracht ist, von derselben isoliert angeordnet. Die isolierende Schicht 114 kann beispielsweise aus einem Feldoxid bestehen. Ein Ende der Basisanschlussleitungen 112 ist mit dem Basisanschluss 108 verbunden. Die anderen Enden der Basisanschlussleitungen 112 sind mit einem ersten Basiskontakt 116 und mit einem zweiten Basiskontakt 118 verbunden. Die Basiskontakte 116 und 118 sind auf einer Planarisierungsschicht 120 angeordnet, die über der Epitaxieschicht 104 abgeschieden ist. Die Planarisierungsschicht 120 ist aus einem isolierenden Material hergestellt, und die Basiskontakte 116 und 118 sind über leitfähige Strukturen 122 mit den Enden der Basisanschlussleitungen 112 elektrisch verbunden.

Die Halbleiterstruktur 100 umfasst ferner einen Emitteranschluss 124, der mit dem Emitterbereich 110 verbunden ist. Wie aus Fig. 1 zu erkennen ist, ist der Emitteranschluss 124 zumindest teilweise auf einer isolierenden Schicht 126 angeordnet. Die isolierende Schicht 126 bedeckt die Basisanschlussleitungen 112, so dass der Emitteranschluss 124 von den Basisanschlussleitungen 112 elektrisch isoliert ist. Der Emitteranschluss 124 ist von dem Basisanschluss 108 durch isolierende Abschnitte 128 elektrisch getrennt. Der Emitteranschluss 124 ist über eine leitfähige Struktur 130, die in der Schicht 120 gebildet sind, mit einem Emitterkontakt 132 verbunden.

Auf der Schicht 120 ist eine Schutzschicht 134 abgeschieden, die die Emitter- und Basiskontakte sowie die frei liegenden Oberflächen der Schicht 120 bedeckt. Über den Anschlussleitungsstrukturen ist eine isolierende Schicht 136 in der Schicht 120 gebildet, wie durch die gestrichelten Linien in Fig. 1 angedeutet ist.

Bei dem in Fig. 1 gezeigten npn-Transistor besteht die einzige Möglichkeit eines ESD-Schutzes dadurch, dass die Anordnung in einer ESD-gesicherten Umgebung angewandt wird, die Halbleiterstruktur selbst umfasst keinerlei Maßnahmen, die den ESD-Schutz verbessern würden.

Tritt jedoch, trotz aller Vorsichtsmaßnahmen, ein ESD-Fall auf, findet also eine elektrostatische Ladung über die Halbleiterstruktur statt, so fließen über den belasteten Strompfad sehr hohe Ströme. Typische Stromdichten liegen hier im Bereich von mehr als etwa 10⁴ A/cm². Bei einer solch hohen Stromdichte bricht - falls die ESD-Belastung über den Kollektor-Basispfad bzw. den Kollektor-Emitterpfad erfolgt - die Kollektor-Basisdiode, also der pn-Übergang zwischen Kollektor 104 und Basis 106 zusammen, und fast die gesamte äußere Spannung liegt am Übergang von Kollektor 104 zu Subkollektor 102 an. In diesem Fall wird die Durchbruch-Feldstärke des Materials des Kollektors und des Subkollektors überschritten, und an dieser Stelle entsteht ein Lawinendurchbruch. Im Fall eines npn-Transistors werden Löcher mit hoher Energie in den Emitter 110 injiziert, und Elektronen werden in den Subkollektor 102 abgesaugt.

Da der Strom bei einem offenen Emitter, welches eine Standard-Testbedingung bei der Untersuchung des Basis-Kollektor-Pfades darstellt, in den Basiskontakt 108 weiterfließen muss, entsteht lateral am Übergang zwischen Emitter 110 und Basis 106 ein sekundärer Lawinendurchbruch, der im Regelfall zur Zerstörung des Bauelements führt.

In Fig. 1 sind die im Falle einer elektrostatischen Entladung auftretenden Strompfade durch die Pfeile 138 und 140 für die jeweiligen Transistoren gezeigt.

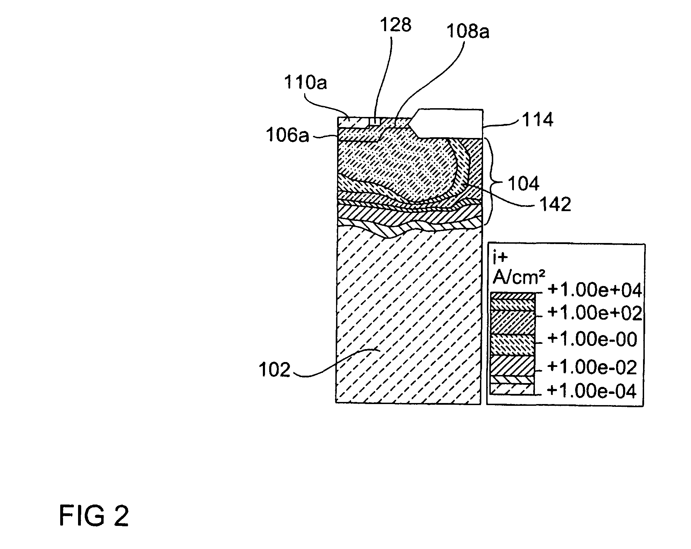

Fig. 2 zeigt als Ergebnis einer Simulation einen vergrößerten Ausschnitt der Halbleiterstruktur aus Fig. 1, und zwar von der Mitte eines Emitterfingers bis zur Mitte eines Basisfingers. In der Fig. 2 ist die Löcher-Stromdichte im ESD-Fall in diesem Bereich dargestellt. Im Subkollektor 102 wird der Strom von Elektronen getragen; daher liegt die Löcher-Stromdichte in einer Größenordnung von etwa 10⁻⁴ A/cm². Im Bereich der Epitaxieschicht 104 steigt die Löcher-Stromdichte von der Grenzfläche zwischen Subkollektor 102 und Epitaxieschicht 104 ausgehend von einem Wert von ca. 10⁻⁴ A/cm² bis auf einen Wert im Bereich von etwa 10⁴ A/cm², der sich im Bereich unterhalb der Isolationsschicht 114, im Bereich des Basisanschlusses 108 sowie im Bereich unter dem Emitter 110 einstellt. Der Bereich der hohen Löcher-Stromdichte von etwa 10⁴ A/cm² erstreckt sich von diesem Bereich unterhalb des Emitters 110, des Basisanschlusses 108 und der Schicht 114 bis zu dem Abschnitt 142, in dem die Löcher-Stromdichte auf etwa 10² A/cm² abfällt. Die Löcher-Stromdichte im Bereich zwischen dem Bereich der höchsten Stromdichte und der Schnittstelle zwischen dem Kollektor und dem Subkollektor fällt von etwa 10⁴ A/cm² über 10² A/cm², 10⁰ A/cm² und 10⁻² A/cm² auf den Wert im Kollektor von etwa 10⁻⁴ A/cm² ab. Ein großer Teil der Löcher diffundiert in den Emitter, rekombiniert dort mit Elektronen und fließt dann nach einem Sekundär-Durchbruch lateral über den Basiskontakt ab.

Das Problem im ESD-Fall ist aus der Fig. 2 ohne weiteres zu erkennen, nämlich die hohe Stromdichte im Bereich unter dem Emitter 110, die zu der hohen Belastung des Emitters 110 führt, was letztendlich zu der Zerstörung des Bauelements aufgrund des Lawinendurchbruchs des pn-Übergangs zwischen Emitter 110 und Basis 106 führen wird.

Der Nachteil der bekannten Halbleiterstrukturen besteht darin, dass kein Verfahren besteht, die ESD-Festigkeit solcher Strukturen, wie z. B. von Hochfrequenz-Transistoren, wie sie anhand der Fig. 1 beschrieben wurden, zu verbessern. Die einzige Möglichkeit die existiert, besteht darin, Bereiche erhöhter Feldstärke, die lokal zu einem früheren Durchbruch und einer erhöhten Stromdichte führen würden, bereits im Entwurfsstadium bzw. in der Prozessentwicklung zu vermeiden. Trotz solcher Vorkehrungen bleibt die ESD-Festigkeit von Hochfrequenz-Transistoren wegen der Notwendigkeiten der Optimierung auf ein gutes Hochfrequenzverhalten (HF-Performance) in der Regel im Vergleich zu NF-Transistoren schlecht.

Ferner ist bei Änderungen im Design/Entwurf zu bedenken, dass diese Änderungen unerwünschte Veränderungen der elektrischen Eigenschaften des in der Halbleiter-Struktur erzeugten Bauelements zur Folge haben können.

DE 42 00 884 offenbart (vgl. Figur 2) eine Halbleiterstruktur, die aus einem p-Substrat gebildet ist, das eine p+-Zone besitzt, die mit dem n+-dotierten Anschlusskontaktbereich und den an die Erde angeschlossenen n+- bzw. p+-Zone ein ESD-Schutztransistor bzw. -diode bildet.

Ausgehend von diesem Stand der Technik liegt der vorliegenden Erfindung die Aufgabe zugrunde, eine verbesserte Halbleiter-Struktur zu schaffen, die gegen eine ESD-Überlastung geschützt ist und gleichzeitig die Eigenschaften der Halbleiterstruktur nicht beeinflusst.

Diese Aufgabe wird durch eine Halbleiterstruktur gemäß Anspruch 1 gelöst.

Die vorliegende Erfindung schafft eine Halbleiterstruktur, mit
einem Substrat;
einer Bauelementschicht, die auf dem Substrat angeordnet ist;
einem Kontakt; und
einer ESD-Schutzeinrichtung, die derart zwischen dem Substrat und dem Kontakt angeordnet ist, dass im ESD-Fall ein Durchbruch von der ESD-Schutzeinrichtung zu dem Kontakt erfolgt.

Der vorliegenden Erfindung liegt die Erkenntnis zugrunde, dass durch die Zwischenordnung der ESD-Schutzeinrichtung zwischen dem Substrat und dem Kontakt im ESD-Fall der Strom außerhalb der empfindlichen Bereiche der Halbleiterstruktur direkt in den Kontakt abfließt. Entlang dieses Pfades ist die dem Strom zur Verfügung stehende Querschnittsfläche, verglichen mit der Querschnittsfläche eines Strompfades durch die empfindlichen Bereiche der Halbleiterstruktur, weitaus größer, so dass erst bei einer sehr viel höheren ESD-Belastungen Schädigungen auftreten werden.

Der Vorteil der vorliegenden Erfindung besteht darin, dass aufgrund der Anordnung der ESD-Schutzeinrichtung zwischen Substrat und Kontakt eine Beeinflussung der Funktionalität der Halbleiterstruktur aufgrund von Veränderungen der übrigen Struktur vermieden wird, so dass das elektrische Verhalten der Halbleiterstruktur nicht beeinträchtigt wird.

Gemäß einem bevorzugten Ausführungsbeispiel der vorliegenden Erfindung wird ein Weg dargelegt, über den die ESD-Stabilität von Hochfrequenztransistoren, wie sie oben anhand der Fig. 1 beschrieben wurden, verbessert wird, ohne dass die Hochfrequenzeigenschaften der Transistoren beeinträchtigt werden, wobei hier speziell die ESD-Stabilität der Basis-Kollektordiode verbessert wird. Der Erfindung liegt diesbezüglich die Erkenntnis zugrunde, dass die ESD-Festigkeit der Kollektor-Basisdiode wesentlich vom Profilverlauf der Kollektordotierung im Übergangsbereich zwischen dem aktiven Kollektor und dem Subkollektor abhängt.

Bei dem bevorzugten Ausführungsbeispiel wird die Hochfrequenztransistor-Struktur am Übergang von Kollektor zu Subkollektor derart modifiziert, dass im Überlastfall der Strom vorzugsweise außerhalb des Emitters direkt in den Basiskontakt abfließt. Entlang dieses Pfades ist die dem Strom zur Verfügung stehende Querschnittsfläche weitaus größer, so erst bei sehr viel höheren ESD-Belastungen eine Schädigung auftreten wird.

Bevorzugte Weiterbildungen der erfindungsgemäßen Halbleiterstruktur sind in den Unteransprüchen definiert.

Nachfolgend werden bezugnehmend auf die beiliegenden Zeichnungen bevorzugte Ausführungsbeispiele der vorliegenden Erfindung näher erläutert. Es zeigen:
Fig. 1 eine Querschnittdarstellung einer bekannten Hochfrequenz-Bipolartransistorstruktur;
Fig. 2 eine simulierte Darstellung der Verteilung der Löcher-Stromdichte in der Umgebung des Basisanschlusses der Hochfrequenz-Basistransistorstruktur aus Fig. 1 im ESD-Fall;
Fig. 3 eine Querschnittdarstellung einer Hochfrequenz-Bipolartransistorstruktur gemäß einem Ausführungsbeispiel der vorliegenden Erfindung; und
Fig. 4 eine simulierte Darstellung der Verteilung der Löcher-Stromdichte in der Umgebung des Basisanschlusses der Hochfrequenz-Bipolartransistorstruktur aus Fig. 3 im ESD-Fall.

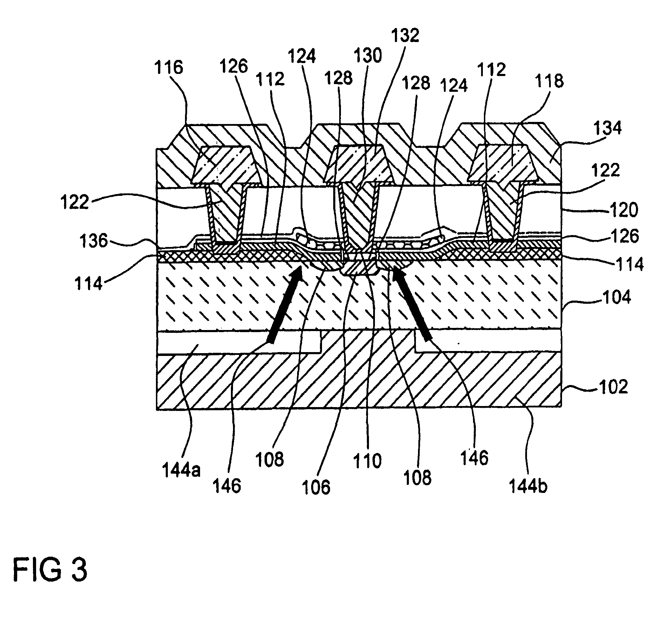

In Fig.3 ist eine Hochfrequenz-Bipolartransistorstruktur gemäß einem bevorzugten Ausführungsbeispiel der Erfindung in einer Querschnittdarstellung gezeigt. Bereits anhand der Fig. 1 beschriebene Elemente und Strukturen sind Fig. 3 mit den gleichen Bezugszeichen versehen, und eine erneute Beschreibung erfolgt nicht.

Vergleicht man die in Fig. 3 dargestellte Halbleiter-Struktur mit der in Fig. 1 dargestellten Halbleiterstruktur gemäß dem Stand der Technik, so ist zu erkennen, dass die erfindungsgemäße Halbleiter-Struktur im Bereich der Grenzfläche zwischen dem Subkollektor 102 und dem Kollektor 104 zusätzlich Zonen erhöhter Dotierung 144a und 144b aufweist. Die Zonen 144a und 144b sind bei dem dargestellten Ausführungsbeispiel derart angeordnet, dass ein Bereich des Subkollektors, der unmittelbar unter einem Emitterfinger liegt, im Vergleich zu einem herkömmlichen Halbleiterbauelement unverändert bleibt, wobei der Bereich außerhalb des Emitterfingers höher dotiert wird. Die Modifikation des Subkollektors in den Zonen 144a und 144b kann beispielsweise durch eine lokale Implantation in dem Substrat 102 unter dem Feldoxid 114 mit einer eigenen Phototechnik vor dem Aufwachsen der Epitaxieschicht 104 durchgeführt werden.

Bei dem in Fig. 3 gezeigten Ausführungsbeispiel der vorliegenden Erfindung haben die Zonen 144a und 144b eine Dotierungsdichte im Bereich von 5x10¹⁸ Atomen/cm³ bis 5x10²⁰ Atomen/cm³, wobei die Zonen vorzugsweise mit Arsen (As) Atomen mit einer Dotierungsdichte von 3x10¹⁹ Atomen/cm³ dotiert werden.

Die ESD-Festigkeit der Halbleiter-Struktur kann durch eine gezielte Einstellung des Dotierstoffprofils am Übergang von Substrat 102 zu Epitaxieschicht 104 verbessert werden, da hierdurch die Feldstärke bei einer vorgegebenen äußeren Spannung am Übergang von Substrat 102 zu Kollektor 104 durch das Dotierungsprofil beeinflusst werden kann. Erhöht man in den Zonen 144a und 144b gezielt die Dotierung des Subkollektors 102, so stellt sich dort im Vergleich zur Umgebung eine erhöhte Feldstärke ein. Somit wird der Lawinendurchbruch dort früher eintreten, und der Strom wird auch bevorzugt durch diese Zonen 144a und 144b fließen. Auf diese Art und Weise kann der Strompfad, wie er durch die Pfeile 146 in Fig. 3 schematisch gezeigt ist, gezielt in Regionen gelenkt werden, in denen mehr Fläche zur Verfügung steht, die also eine größere Querschnittsfläche aufweisen, so dass der Strom weniger Schaden anrichtet.

Die Zonen 144a und 144b sind derart angeordnet, dass diese ungefähr um eine Entfernung voneinander beabstandet sind, die gleich der lateralen Erstreckung der Basis der in Fig. 3 gezeigten Halbleiterstruktur ist, die sich aus dem Basisbereich 106 sowie dem Basisanschluss 108 zusammensetzt. Im ESD-Fall wird der Strom nicht über den empfindlichen Basisbereiche 106 und den empfindlichen Emitterbereiche 110 geleitet, sondern vom Subkollektor 102 über die Zonen 144a und 144b direkt zu dem Basisanschluss 108 (siehe Pfeil 146).

Obwohl in Fig. 3 ein Beispiel anhand eines npn-Transistors beschrieben wurde, ist offensichtlich, dass die erfindungsgemäße ESD-Schutzeinrichtung auch bei pnp-Transistoren Anwendung finden würde. Ebenso ist offensichtlich, dass die erfindungsgemäße ESD-Schutzeinrichtung auch auf eine Transistorkonstruktion anwendbar ist, bei der der Kollektoranschluss nach oben herausgezogen ist.

Ein Vorteil der vorliegenden Erfindung besteht darin, dass keine Modifikationen der in der Halbleiterstruktur gebildeten Bauelemente zur Verbesserung des ESD-Schutzes erforderlich sind, da die erforderlichen Modifikationen im Bereich des Substrats 102 durchgeführt werden. Somit werden durch die Änderungen auch die Signaleigenschaften der erzeugten Halbleiterstruktur, im vorliegenden Fall das Hochfrequenz-Verhalten der Transistoren, nicht nachteilig beeinflusst. Ferner kann die Erzeugung der Zonen ohne weiteres in existierende Herstellungsabläufe eingebettet werden.

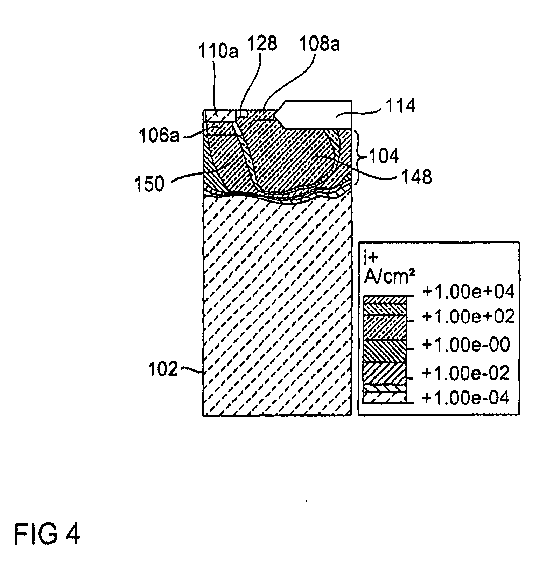

Anhand der Fig. 4 wird nun die Auswirkung der Einfügung der Zonen 144a und 144b auf die Stromdichteverteilung näher erläutert, wobei hier, ähnlich wie in Fig. 2, der Bereich um den Basisanschluss 108 des Transistors aus Fig. 3 näher betrachtet wird.

Im Bereich des Substrats bzw. Subkollektors 102 liegt die Löcher-Stromdichte im ESD-Fall bei etwa 10⁻⁴ A/cm². Ähnlich wie in Fig. 2 steigt die Löcher-Stromdichte ausgehend von der Grenzfläche zwischen dem Subkollektor 102 und dem Kollektor 104 von einem Wert von etwa 10⁻⁴ A/cm² auf einen Maximalwert von etwa 10⁴ A/cm² an. Die hohe Stromdichte ist im wesentlichen auf einen Bereich 148 unterhalb des Basisanschlusses 108 und der Feldoxidschicht 114 beschränkt. Ausgehend von dem Bereich 148 mit der höchsten Löcher-Stromdichte fällt die Stromdichte über Werte 10² A/cm², 10⁰ A/cm², 10⁻² A/cm² auf etwa 10⁻⁴ A/cm² im Bereich der Grenzfläche zwischen Subkollektor 102 und Kollektor 104 ab. Ein Bereich 150 unmittelbar unter dem Emitter 110 und dem Basisbereich 106 hat eine deutlich niedrigere Löcher-Stromdichte, als die unter dem Anschluss 108 liegenden Bereiche, wobei die Löcher-Stromdichte hierbei etwa 10² A/cm² liegt, verglichen mit einer Löcher-Stromdichte, die bei herkömmlichen Transistoren in demselben Bereich bei etwa 10⁴ A/cm² liegt.

Aus den Fig. 2 und 4 ist die Stromdichte des Löcherstroms zu erkennen, und beim modifizierten Subkollektor fließt der größte Teil des Stroms direkt zum Basisanschlussgebiet 108 und der Emitter wird nur gering belastet. Aus Fig. 4 ist deutlich die Verbesserung zu erkennen, gegenüber herkömmlichen Halbleiterstrukturen durch die erfindungsgemäße ESD-Schutzeinrichtung erreichbar ist.

Es sei darauf hingewiesen, dass die vorliegende Erfindung nicht auf das anhand der Fig. 3 und der Fig. 4 beschriebene Ausführungsbeispiel beschränkt ist. Die vorliegende Erfindung bezieht sich allgemein auf Halbleiterstrukturen, welche neben einem Substrat und einem Bauelement eine ESD-Schutzeinrichtung im Bereich des Substrats aufweisen, die im ESD-Fall einem Durchbruch von dem Substrat zu einem vorgesehenen Kontakt bewirken, so dass ESD-empfindliche Bereich bzw. Bereiche in der Halbleiterstruktur, die gegenüber hohen Strömen empfindlich sind, "umgangen" werden, der zu hohe Strom also an diesen Bereichen vorbei direkt in den Kontakt geleitet wird.

Die vorliegende Erfindung ist ferner nicht auf die in Fig. 3 gezeigte Ausführung der ESD-Schutzeinrichtung beschränkt. Anstelle der dort gezeigten hoch dotierten Zonen in dem Substrat können diese beispielsweise auch in der Epitaxieschicht oder auf dem Substrat oder in einer Zwischenschicht, die zwischen dem Substrat und der Epitaxieschicht 104 angeordnet ist, vorgesehen sein. Anstelle der hoch dotierten Zonen, kann die ESD-Schutzeinrichtung auch durch Bereiche mit einem anderen Halbleitermaterial gebildet werden. Die vorliegende Erfindung ist ferner nicht auf die Anwendung im Bereich von Bipolartransistoren beschränkt, sondern bezieht sich allgemein auf Halbleiterstrukturen, bei denen ein Strom im Durchbruchfall an den empfindlichen Bereichen vorbei geführt werden muss, wie beispielsweise Dioden und ähnliches.

### Bezugszeichenliste

- 102: Substrat
- 104: Epitaxieschicht
- 106: Basisbereich
- 108: Basisanschluss
- 110: Emitterbereich
- 112: Basisanschlussleitung
- 114: isolierende Schicht
- 116: Basiskontakt
- 118: gemeinsamer Basiskontakt
- 120: Planarisierungsschicht
- 122: leitfähige Strukturen
- 124: Emitterarischluss
- 126: isolierende Schicht
- 128: isolierender Abschnitt
- 130: leitfähige Struktur
- 132: Emitterkontakt
- 134: Schutzschicht
- 136: isolierende Schicht
- 138: Pfeil
- 140: Pfeil
- 142: Bereich mittlerer Stromdichte
- 144a,144b: Zone mit hoher Dotierung
- 146: Pfeil
- 148: Bereich hoher Stromdichte
- 150: Bereich mittlerer Stromdichte

## Patentansprüche

1. Halbleiterstruktur, mit
einem Substrat (102);
einer Bauelementschicht (104), die auf dem Substrat (102) angeordnet ist und einen Kollektor bildet, wobei ferner eine Basis (106) und ein Emitter (110) in der Bauelementschicht (104) gebildet sind, und wobei der Basis (106) ein in der Bauelementschicht (104) gebildeter Anschlusskontaktbereich (108) zugeordnet ist; und
einer oder mehreren Zonen (144a, 144b) als eine ESD-Schutzeinrichtung, die zwischen dem Substrat (102) und dem Anschlusskontaktbereich (108) gebildet sind,
wobei die eine oder mehreren Zonen (144a, 144b) außerhalb eines Bereichs, der dem Emitter (110) gegenüberliegt, gebildet sind und eine Dotierungskonzentration aufweisen, die höher ist als in dem Substrat (102), so dass im ESD-Fall ein Durchbruch von der einen oder den mehreren Zonen (144a, 144b) zu dem Anschlusskontaktbereich (108) der Basis (106) erfolgt.

2. Halbleiterstruktur nach Anspruch 1, bei der in dem Substrat (102) ein Subkollektor gebildet ist, und bei der die eine oder mehreren Zonen (144a, 144b) in dem Subkollektör, in dem Kollektor oder zwischen dem Subkollektor und dem Kollektor gebildet sind und eine Dotierungskonzentration aufweisen, die höher ist als in dem Subkollektor.

3. Halbleiterstruktur nach Anspruch 1 oder 2, bei der die eine oder mehreren Zonen (144a, 144b) außerhalb eines Bereichs angeordnet ist, der einem Bereich gegenüberliegt, der durch die Basis (106) und den Anschlusskontaktbereich (108) der Basis festgelegt ist.

4. Halbleiterstruktur nach Anspruch 2 oder 3, bei der das Dotierungsprofil der einen oder mehreren Zonen (144a, 144b) steiler zu der Bauelementschicht (104) abfällt als im Bereich des Subkollektors, wobei die Bauelementschicht (104) eine Epitaxieschicht ist.

5. Halbleiterstruktur nach Anspruch 2 oder 3, bei das Dotierungsprofil der einen oder mehreren Zonen (144a, 144b) weiter in den Kollektor hineinreicht als das Dotierungsprofil des Subkollektors.

6. Halbleiterstruktur nach Anspruch 2 oder 3, bei der die eine oder mehreren Zonen (144a, 144b) in einer zwischen dem Kollektor und dem Subkollektor angeordnete Zwischenschicht gebildet sind.

7. Halbleiterstruktur nach einem der Ansprüche 1 bis 6, bei der die eine oder mehreren Zonen (144a, 144b) eine Dotierungskonzentration im Bereich von 5x10¹⁸ Atomen/cm³ bis 5x10²⁰ Atomen/cm³ hat.

8. Halbleiterstruktur nach einem der Ansprüche 1 bis 7, bei der die eine oder mehreren Zonen (144a, 144b) aus einem Halbleitermaterial hergestellt ist, das eine niedrigere Durchbruchfeldstärke besitzt.

## Claims

1. Semiconductor structure, comprising
a substrate (102);
a device layer (104) arranged on the substrate (102) and forming a collector, wherein a base (106) and an emitter (110) are formed in the device layer (104), and wherein the base (106) is associated a terminal contact area (108) formed in the device layer (104); and
one or more zones (144a, 144b) as ESD protective means, which are arranged between the substrate (102) and the terminal contact area (108),
wherein the one or more zones (144a, 144b) are formed outside an area which is opposite the emitter (110) and have a doping concentration higher than that in the substrate (102), such that in the ESD case a breakthrough occurs from the one or the more zones (144a, 144b) to the terminal contact area (108) of the base (106).

2. Semiconductor structure according to claim 1, wherein a subcollector is formed in the substrate (102), and wherein the one or more zones (144a, 144b) are formed in the subcollector, in the collector or between the subcollector and the collector and have a doping concentration which is higher than the doping concentration of the subcollector.

3. Semiconductor structure according to claim 1 or 2, wherein the one or more zones (144a, 144b) are arranged outside an area which is opposite an area determined by the base (106) and the terminal contact area (108) of the base.

4. Semiconductor structure according to claim 2 or 3, wherein the doping profile of the one or more zones (144a, 144b) falls steeper to the device layer (104) than in the area of the subcollector, wherein the device layer (104) is an epitaxy layer.

5. Semiconductor structure according to claim 2 or 3, wherein the doping profile of the one or more zones (144a, 144b) extends further into the collector than the doping profile of the subcollector.

6. Semiconductor structure according to claim 2 or 3, wherein the one or more zones (144a, 144b) are formed by a interlayer arranged between the collector and the subcollector.

7. Semiconductor structure according to one of claims 1 to 6, wherein the one or more zones (144a, 144b) have a doping concentration in the range of 5 x 10¹⁸ atoms/cm³ to 5 x 10²⁰ atoms/cm³.

8. Semiconductor structure according to one of claims 1 to 7, wherein the one or more zones (144a, 144b) are produced of a semiconductor material having a low breakthrough field strength.

## Revendications

1. Structure à semi-conducteurs comprenant
un substrat (102) ;
une couche (104) de composant, qui est disposée sur le substrat (102) et qui forme un collecteur, une base (106) et un émetteur (110) étant formés, en outre, dans la couche (104) de composant et une partie de contact de borne formée dans la couche (104) de composant étant associée à la base (106) ; et
une ou plusieurs zones (144a, 144b), en tant que dispositif de protection vis-à-vis d'une ESD, qui sont formées entre le substrat (102) et la partie (108) de contact de borne ;
la zone ou les plusieurs zones (144a, 144b) étant formées à l'extérieur d'une partie qui est opposée à l'émetteur (110) et ayant une concentration de dopage qui est plus grande que celle du substrat (102), de sorte qu'en cas d'ESD, il se produit un claquage de la zone ou des plusieurs zones (144a, 144b) à la partie (108) de contact de borne de la base (106).

2. Structure à semi-conducteurs suivant la revendication 1, dans laquelle il est formé dans le substrat (102) un sous-collecteur et dans laquelle la zone ou les plusieurs zones (144a, 144b) sont formées dans le sous-collecteur, dans le collecteur ou entre le sous-collecteur et le collecteur et ont une concentration de dopage qui est plus grande que celle du sous-collecteur.

3. Structure à semi-conducteurs suivant la revendication 1 ou 2, dans laquelle la zone ou les plusieurs zones (144a, 144b) sont disposées à l'extérieur d'une partie qui est opposée à la partie qui est déterminée par la base et par la partie (108) de contact de borne de la base.

4. Structure à semi-conducteurs suivant la revendication 2 ou 3, dans laquelle le profil de dopage de la zone ou des plusieurs zones (144a, 144b) décroît de manière plus abrupte vers la couche (104) de composant que dans la partie du sous-collecteur, la couche (104) de composant étant une couche d'épitaxie.

5. Structure à semi-conducteurs suivant la revendication 2 ou 3, dans laquelle le profil de dopage de la zone ou des plusieurs zones (144a, 144b) va plus loin dans le collecteur que le profil de dopage du sous-collecteur.

6. Structure à semi-conducteurs suivant la revendication 2 ou 3, dans laquelle la zone ou les plusieurs zones (144a, 144b) sont formées dans une couche intermédiaire disposée entre le collecteur et le sous-collecteur.

7. Structure à semi-conducteurs suivant l'une des revendications 1 à 6, dans laquelle la zone ou les plusieurs zones (144a, 144b) ont une concentration de dopage de l'ordre de 5 x 10¹⁸ atomes/cm³ à 5 x 10²⁰ atomes/cm³.

8. Structure à semi-conducteurs suivant l'une des revendications 1 à 7, dans laquelle la zone ou les plusieurs zones (144a, 144b) sont en un matériau semi-conducteur qui a une intensité de champ de claquage assez petite.
